Europäisches Patentamt

European Patent Office

Office européen des brevets

(19)

(11) Veröffentlichungsnummer : **0 267 375 B1**

(12) **EUROPÄISCHE PATENTSCHRIFT**

(45) Veröffentlichungstag der Patentschrift :
05.06.91 Patentblatt 91/23

(51) Int. Cl.⁵ : **G01N 24/08, A61B 5/02**

(21) Anmeldenummer : **87111228.0**

(22) Anmeldetag : **04.08.87**

(54) **Verfahren zum Bestimmen von beweglichem Material innerhalb eines Körpers.**

(30) Priorität : **16.08.86 DE 3627750**

(43) Veröffentlichungstag der Anmeldung :
**18.05.88 Patentblatt 88/20**

(45) Bekanntmachung des Hinweises auf die
Patenterteilung :
**05.06.91 Patentblatt 91/23**

(84) Benannte Vertragsstaaten :
**CH DE FR GB LI**

(56) Entgegenhaltungen :
**EP-A- 0 124 016**
**EP-A- 0 126 381**
**EP-A- 0 171 070**
**EP-A- 0 205 136**
**GB-A- 2 164 155**
**US-A- 4 574 240**
**US-A- 4 602 641**

(73) Patentinhaber : **Spectrospin AG**
**Industriestrasse 26**
**CH-8117 Zürich-Fällanden (CH)**

(72) Erfinder : **Müri, Marcel**
**Im Lindengut 9**
**CH-8803 Rüschlikon (CH)**
Erfinder : **Hennig, Jürgen**
**Johann-von Werth-Strasse 12**
**W-7800 Freiburg (DE)**
Erfinder : **Brunner, Peter**
**Im Roggenacher 7**
**CH-8306 Brüttisellen (CH)**

(74) Vertreter : **KOHLER SCHMID + PARTNER**
**Patentanwälte**
**Ruppmannstrasse 27**
**W-7000 Stuttgart 80 (DE)**

**Beschreibung**

Die Erfindung betrifft ein Verfahren zum Bestimmen von beweglichem, insbesondere fließendem Material gemäß dem Oberbegriff des Patentanspruchs 1.

Ein solches Verfahren ist aus der EP-A 0 171 070 bekannt.

D.A. Feinert et al haben in Magn. Reson. in Med. 2, 555 (1985) Verfahren zum Bestimmen von beweglichem, insbesondere fließendem Material innerhalb eines Körpers mittels NMR-Tomographie beschrieben, bei dem der Körper einem homogenen Magnetfeld und periodisch aufeinanderfolgend impulsförmig angelegten Gradientenfeldern sowie zu den Gradientenfeldern zeitlich synchronisierten HF-Anregungsimpulsen ausgesetzt wird und die Gradientenfelder derart variiert werden, daß bei jeder durch einen HF-Anregungsimpuls ausgelösten Meßsequenz die sich in einem ausgewählten Bereich des Körpers befindenden Spins angeregt und zur Erzeugung von Spinechosignalen veranlaßt werden und durch Fourier-Transformation eines Satzes der während der Meßsequenzen empfangenen Spinechosignale neben der räumlichen Auflösung des ausgewählten Bereiches auch eine Information über die Geschwindigkeit des beweglichen Materials erhalten wird, das sich innerhalb dieses Bereiches befindet.

Dabei werden sowohl zur Leserichtung als auch zur Richtung eines Scheibenselektionsgradienten parallele Flußcodierungsgradienten in Verbindung mit einer HF-Pulssequenz verwendet, bei der das Spinechosignal durch einen 90°-Anregungsimpuls und einen nachfolgenden 180°-Reversierungsimpuls erzeugt wird.

Ein Nachteil dieses bekannten Verfahrens besteht darin, daß das bewegliche, insbesondere fließende Material nur ein sehr schwaches Signal liefert, weil das in Leserichtung codierte bewegliche Material während des gesamten Satzes von gewöhnlich 128 oder 256 Meßsequenzen mehrfach den zur Signalerzeugung dienenden HF-Impulsen ausgesetzt und dadurch gesättigt wird. Das Vermeiden einer solchen Sättigung erfordert lange Repetitionszeiten, welche eine Anwendung des Verfahrens als 3DFT-Verfahren ausschließen, weil die dann benötigten Meßzeiten im Bereich einiger Stunden liegen würden. Insbesondere dann, wenn das Verfahren für klinische Untersuchungen am menschlichen Körper angewendet wird, sind solche Meßzeiten für Patienten unzumutbar. Außerdem würden sich durch die im Laufe einer solchen Meßzeit unvermeidlichen Bewegungen des Meßobjekts Fehler ergeben, welche den Erfolg der gesamten Messung überhaupt in Frage stellen könnten.

Ein anderer Nachteil ergibt sich daraus, daß Material, welches in Richtung des Scheibengradienten fließt, nicht in vollem Umfang dem der Signalerzeugung dienenden Teil der Meßfrequenz ausgesetzt ist, da es in der Zeit zwischen dem 90°-Impuls teilweise sogar ganz aus der untersuchten Scheibe ausgeflossen sein kann. Dieser Effekt ist umso gravierender, je höher die Fließgeschwindigkeit ist. Auch hierdurch ergibt sich eine Verminderung der Signalausbeute, was insbesondere die Anwendbarkeit im klinischen Betrieb stark beeinträchtigt.

In einem Aufsatz von P.R. Moran in Magn. Reson. Imaging 1, 197 (1982) ist die allgemeine Theorie behandelt, die dem erfindungsgemäßen Verfahren zugrundeliegt. Nach dieser Theorie ist es möglich, ein sechsdimensionales Bild zu erzeugen, von dessen Dimensionen drei der Darstellung des Bildinhaltes in Bezug auf drei Raumachsen und die anderen drei der Angabe von Fließgeschwindigkeiten längs der Raumachsen zugeordnet sind. Für die Praxis ist ein solches Bild allerdings zu kompliziert. Es lassen sich jedoch unter Beschränkung der Dimensionen einfachere und brauchbare Bilder erzeugen. Dabei wird jedoch immer die Fließgeschwindigkeit wenigstens in Richtung des Lesegradienten gemessen. Damit haben auch die aus dieser Druckschrift bekannten Verfahren den oben behandelten Nachteil, daß eine unerwünschte Sättigung eintritt, wenn nicht sehr lange Repetitionszeiten eingehalten werden, was bei vielen Anwendungszwecken nicht möglich ist. Das gleiche gilt auch für das Verfahren, das aus dem Aufsatz von T.W. Redpath et al. in Phys. Med. Biol. 29 (7), 891 (1984) bekannt ist.

Bei der zum Oberbegriff des Patentanspruchs 1 angeführten EP-A 0 171 070 folgen einem während eines Selektionsgradienten in Z-Richtung eingestrahlten HF-90°-Anregungssignal mehrere nicht selektive 180°-Impulse. Demnach besteht eine Anregungssequenz aus mehreren Hochfrequenz-Anregungsimpulsen. Dadurch ist die Repetitionszeit für die einzelnen Meßsequenzen verlängert. Dieses bekannte Verfahren ist aufgrund der aufeinanderfolgenden Hochfrequenz-Signale der Anregungssequenz wenig dazu geeignet, pulsierendes Material zu untersuchen.

Es ist Aufgabe der Erfindung, das gattungsgemäße Verfahren derart auszubilden, daß Messungen ohne Rücksicht auf eine Sättigung mit kurzen Repetitionszeiten für die einzelnen Anregungssequenzen ausgeführt werden können, trotzdem ein deutliches, gut auswertbares Signal erzeugt werden kann und das auch für die Untersuchung von pulsierendem Material geeignet ist.

Diese Aufgabe wird durch die im Patentanspruch 1 angegebenen Merkmale gelöst.

Die davon abhängigen Patentansprüche beschreiben vorteilhafte Weiterbildungen davon.

Bei dem vorgeschlagenen Verfahren wird demnach ein Bild gewonnen, das über eine in der Scheibenebene liegenden Ortskoordinate die Strömungsgeschwindigkeit von fließendem Material anzeigt, das sich in einem auf diese Ortskoordinate projizierten Abschnitt des angeregten, scheibenförmigen Bereiches befindet. Ein solches Bild ist häufig ausreichend, um die so bestimmten Strömungsgeschwindigkeiten Gefäßen, also beispielsweise Adern in einem Körperquerschnitt, zuzuordnen. Daher läßt sich auf diese Weise mit einem einzigen Satz Meßsequenzen eine eindeutige Aussage über das in einem angeregten, scheibenförmigen Bereich vorhandene, bewegliche Material und dessen Strömungsgeschwindigkeit machen. Gleichzeitig haben die erhaltenen Signale ein gutes Signal/Rausch-Verhältnis. Ein besonderer Vorteil besteht noch darin, daß nur ein einziger HF-Impuls zur Anregung benötigt wird und daher das gesamte in dem scheibenförmigen Bereich enthaltene Material der Signalerzeugungssequenz ausgesetzt ist und dementsprechend auch Beiträge zum Ausgangssignal liefert.

Die Sättigung des stationären Materials und damit das Signal-Rausch-Verhältnis kann noch dadurch verbessert werden, daß die zur Erzeugung eines Signalsatzes erforderlichen Anregungen so dicht aufeinanderfolgen, daß bei Einstrahlen eines HF-Anregungsimpulses die durch die verhergehende Meßsequenz bewirkte Anregung noch nicht abgeklungen ist. Das stationäre Material des angeregten scheibenförmigen Bereiches kann dann überhaupt keinen Anteil mehr zu dem Ausgangssignal liefern, das der erwähnten 2DFT-Rekonstruktion zugeführt wird. Es können dann nur noch solche Spins kohärent angeregt werden und ein Signal liefern, die von beweglichem Material stammen, das frisch in den gesättigten Bereich gelangt ist und bei der jeweils letzten Meßsequenz erstmalig angeregt wird.

Für den Fall, daß eine ausreichend schnelle Wiederholung der einzelnen Meßsequenzen aus irgendwelchen Gründen nicht ohne weiteres möglich ist, kann eine vollständige Sättigung des stationären Materials auch leicht dadurch erreicht werden, daß der Körper nach dem ersten HF-Impuls einem schnell wechselnden Gradientenfeld ausgesetzt wird, das durch Dephasierung der angeregten Spins eine wenigstens annähernd vollständige Sättigung des angeregten Bereiches bewirkt. Nach einer gewissen Zeit wird dann ein weiterer HF-Impuls zur Anregung von beweglichem Material eingestrahlt, das nach dem ersten HF-Impuls in den zuvor gesättigten Bereich gelangt ist und das dann die Spinechosignale liefert.

Das erfindungsgemäße Verfahren ist auch besonders dazu geeignet, pulsierendes Material zu untersuchen, weil die das Meßsignal auslösende Anregung durch einen einzigen HF-Impuls und daher zur einem genau definierten Zeitpunkt erfolgt. Daher besteht die Möglichkeit, in weiterer Ausgestaltung der Erfindung die HF-Impulse synchron zur Periode des pulsierenden Materialstroms auszulösen und damit die Messung jeweils zu einem genau definierten Zeitpunkt innerhalb der Periode des pulsierenden Materialstromes vorzunehmen. Auf diese Weise ist es insbesondere möglich, den zeitlichen Verlauf der Strömungsgeschwindigkeit des Blutes in den Adern eines Lebewesens in Abhängigkeit vom Pulsschlag zu untersuchen, indem die Meßsequenzen von einem EKG getriggert und die Messungen mit unterschiedlichen zeitlichen Abständen vom Triggerimpuls des EKG durchgeführt werden. Dabei wäre es auch möglich, während jeder Periode des pulsierenden Materialstromes mehrere durch HF-Impulse angeregte Meßsequenzen auszulösen, ohne daß dabei der Flußphasengradient geändert wird, und für die 2DFT-Rekonstruktion diejenigen Spinechosignale zu Sätzen zusammenzufassen, die von der gleichen Meßsequenz innerhalb der Perioden des pulsierenden Materialstromes stammen. Auf diese Weise erhält man eine Serie zeitlich aufeinanderfolgender Flußprofil-Bilder oder eine Zeitserie von Geschwindigkeitsdiagrammen, welche die zeitliche Entwicklung der Fließgeschwindigkeit des Blutes zwischen zwei Pulsschlägen wiedergibt.

Wie oben erwähnt, liefern die bisher beschriebenen Ausführungsformen des erfindungsgemäßen Verfahrens Angaben über die Strömungsgeschwindigkeit beweglichen Materials, das den angeregten scheibenförmigen Bereich quer durchdringt, über einer in der Ebene dieses Bereiches liegenden Koordinate. Sollte die Projektion des Bereiches auf diese Koordinate nicht ausreichend sein, um die einzelnen Geschwindigkeitsprofile den Stellen des scheibenförmigen Bereiches zuzuordnen, an denen sich das bewegliche Material befindet, so besteht natürlich die Möglichkeit, wie aus der NMR-Tomographie allgemein bekannt, mehrere Signalsätze unter Verwendung von Lesegradienten unterschiedlicher Richtung aufzunehmen und die so erhaltenen Signale zu einem Bild des angeregten scheibenförmigen Bereiches zu verarbeiten. Es werden im allgemeinen wenige Signalsätze genügen, die ein grobes "Schnellbild" des scheibenförmigen Bereiches ergeben, das jedoch als Referenzbild ausreichend ist, um die Flußprofile denjenigen Stellen des scheibenförmigen Bereiches eindeutig zuzuordnen, an denen sich fließendes Material befindet. Diese übliche Technik läßt sich natürlich durch Erhöhen der Anzahl der verwendeten Signalsätze beliebig verfeinern. Statt dessen wäre es dann aber auch möglich, daß der Körper nach der Anregung durch einen HF-Impuls, vorzugsweise im Intervall zwischen den Abschnitten des Flußphasengradienten, in einer zur Richtung des Selektionsgradienten senkrechten und von der Richtung des Lesegradienten abweichenden, vorzugsweise zu dessen Richtung ebenfalls senkrechten Richtung einem Ortsphasengradienten ausgesetzt wird, dessen Größe nach jeweils einem sich aus der Variation des Flußphasengradienten ergebenden vollständigen Satz von Meßsequenzen geändert wird, und daß dann die erhaltenen Spinechosignale noch einer 3DFT-Rekonstruktion unterworfen werden, so daß sie ein zweidimensionales Bild ergeben, dem dann in der dritten Dimension die Strömungsgeschwindigkeiten zugeordnet sind.

Ein Ortsphasengradient kann aber nicht nur dann eingesetzt werden, wenn ein zweidimensionales Bild erzeugt werden soll, dem in der dritten Dimension die Strömungsgeschwindigkeiten zugeordnet sind, sondern ein solcher Phasengradient, der dann eine konstante Größe hat, kann auch zur Dephasierung und damit zur Unterdrückung der Signale großflächiger Strukturen beitragen.

Endlich bietet das erfindungsgemäße Verfahren die Möglichkeit, mehrere Sätze von Spinechosignalen für mehrere parallele Scheiben zu erzeugen und diese Sätze zu einer dreidimensionalen Darstellung des Fließverhaltens über eine gewisse Länge des untersuchten Körpers zu verarbeiten.

Die Erfindung wird im folgenden anhand der in der Zeichnung dargestellten Ausführungsbeispiele näher beschrieben und erläutert. Die der Beschreibung und der Zeichnung zu entnehmenden Merkmale können bei anderen Ausführungsformen der Erfindung einzeln für sich oder zu mehreren in beliebiger Kombination Anwendung finden. Es zeigen :

Fig. 1 das Zeitdiagramm einer ersten Ausführungsform des erfindungsgemäßen Verfahrens,

Fig. 2 die Wiedergabe eines mit dem Verfahren nach Fig. 1 gewonnenen Bildes,

Fig. 3 und 4 die Zeitdiagramme weiterer Ausführungsformen des erfindungsgemäßen Verfahrens,

Fig. 5 und 6 unter Verwendung des erfindungsgemäßen Verfahrens konstruierte Bilder,

Fig. 7 das Zeitdiagramm einer weiteren Ausführungsform des erfindungsgemäßen Verfahrens und

Fig. 8 unter Verwendung der Ausführungsform des erfindungsgemäßen Verfahrens nach Fig. 7 erhaltene Bilder.

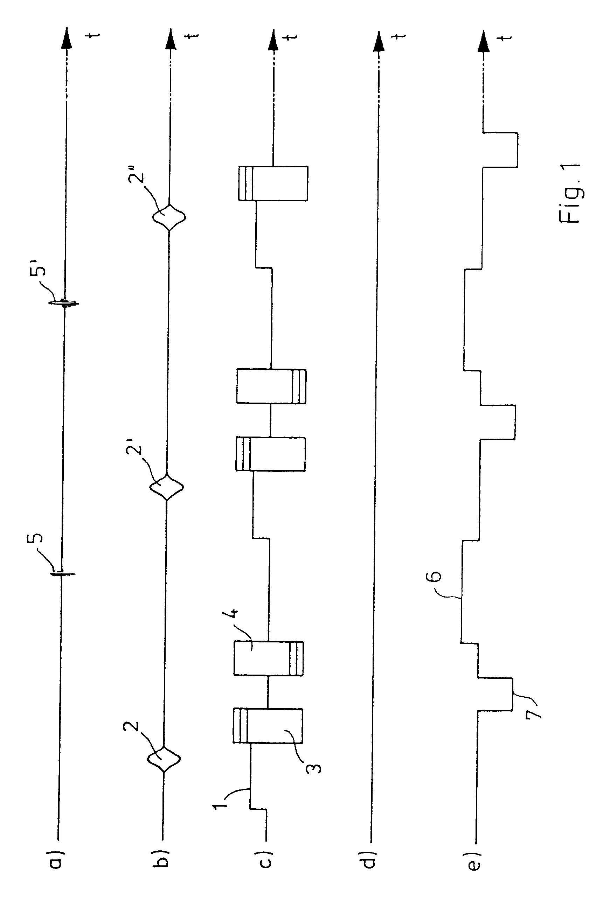

Bei den in den Fig. 1, 3, 4 und 7 dargestellten Zeitdiagrammen von Ausführungsformen des erfindungsgemäßen Verfahrens sind jeweils auf einer Zeitachse in der Zeile (a) die ausgelösten Spinechosignale, in der Zeile (b) die der Anregung dienenden HF-Impulse und in den Zeilen (c), (d) und (e) pulsartig angelegte Gradientenfelder dargestellt, die bei den behandelten Ausführungsbeispielen des erfindungsgemäßen Verfahrens aufeinander senkrecht stehen. Dabei ist die Richtung des in Zeile (c) angegebenen Gradientenfeldes senkrecht zu dem angeregten, scheibenförmigen Bereich (Richtung des Selektionsgradienten), während die Richtungen der in den Zeilen (d) und (e) angegebenen Gradientenfelder innerhalb der Scheibenebene liegen. Dabei definiert der in Zeile (e) angegebene Gradient die Leserichtung (Lesegradient).

Bei der in Fig. 1 dargestellten, einfachsten Ausführungsform des erfindungsgemäßen Verfahrens wird der zu untersuchende Körper einem Selektionsgradienten 1 und gleichzeitig einem HF-Impuls 2 ausgesetzt, so daß ein zur Richtung des Selektionsgradienten 1 senkrechter, scheibenförmiger Bereich des Körpers angeregt wird. Die Lage und die axiale Ausdehnung dieses Bereiches richten sich nach der Größe des Selektionsgradienten, der Trägerfrequenz und der Form des HF-Impulses. Gewöhnlich handelt es sich bei dem HF-Impuls 2 um einen 90°-Impuls, obwohl auch die Anwendung von HF-Impulsen möglich ist, die davon abweichende Flipwinkel erzeugen.

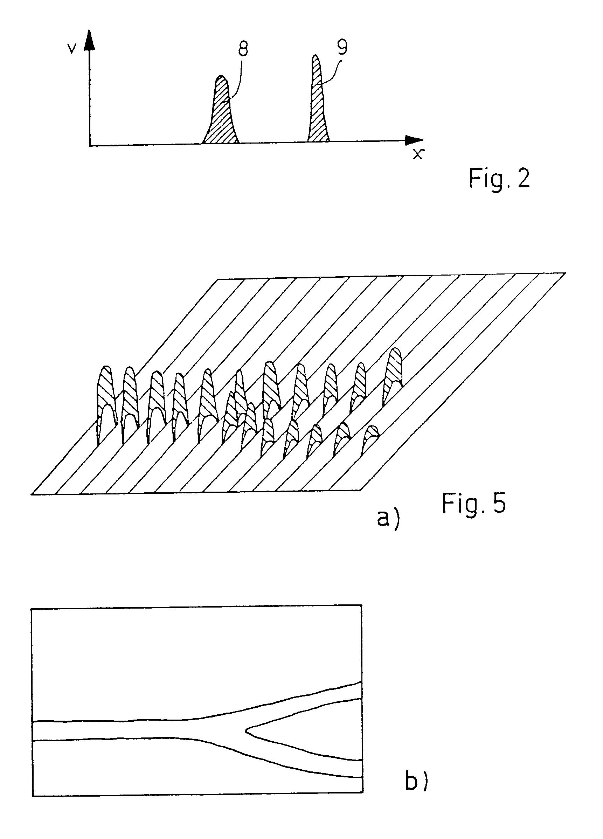

Nach Anregen des scheibenförmigen Bereiches wird der Körper zwei mit zeitlichem Abstand aufeinanderfolgenden Anteilen eines Flußphasengradienten ausgesetzt. Die Richtung dieses Flußphasengradienten fällt mit der Richtung des Selektionsgradienten zusammen, weshalb diese Anteile in der gleichen Zeile (c) der Fig. 1 dargestellt sind wie dieser Selektionsgradient 1. Die Anteile 3, 4 des Flußphasengradienten sind entgegengesetzt gleich, so daß sich ihre Wirkungen auf das in der angeregten Scheibe enthaltene, stationäre Material aufheben. Ist dagegen in der Scheibe in Richtung des Fluß phasengradienten, also quer zur Scheibe fließendes Material vorhanden, so sind infolge der örtlichen Verschiebung dieses Materials in dem Zeitintervall zwischen den beiden Anteilen 3, 4 die Wirkungen dieser Gradientenimpulse auf das bewegte Material verschieden, so daß das Integral über die beiden Anteile 3, 4 des Flußphasengradienten eine dephasierende Wirkung auf die Spins des bewegten Materials ergibt, deren Induktionssignal nach der Anregung durch den HF-Impuls 2 schnell abgeklungen ist. Während des Auftretens des Spinechosignales 5 wird ein in der Ebene der angeregten Scheibe liegender Lesegradient 6 angelegt, dem ein entgegengesetzt gerichteter Gradientenimpuls 7 im Bereich zwischen den Anteilen 3 und 4 des Flußphasengradienten vorausgeht, der zusammen mit dem Lesegradienten 6 ein ebenfalls zur Bildung eines Signalechos führendes Umkehrschema darstellt. Die beschriebene Meßsequenz wird unter Änderung der Größe des Flußphasengradienten mehrfach wiederholt, so daß eine Vielzahl von Spinechosignalen 5, 5' usw. erhalten wird, die dann in üblicher Weise einer 2DFT-Rekonstruktion unterworfen werden. Anstelle des sonst erhaltenen zweidimensionalen Bildes wird bei Anwendung des erfindungsgemäßen Verfahrens ein Bild erhalten, das über der durch den Lesegradienten 6 definierten x-Richtung die Geschwindigkeit v des beweglichen Materials aufzeigt, das sich in den auf die x-Richtung des Lesegradienten projizierten Bereichen der angeregten Scheibe befindet, wie es in Fig. 2 durch die Peaks 8, 9 angedeutet ist. Wenn sich in den zur x-Richtung senkrechten Bereichen jeweils nur eine Stelle befindet, an der der angeregte scheibenförmige Bereich bewegliches Material enthält, sind die durch die Peaks 8, 9 dargestellten Geschwindigkeitsinformationen diesen Stellen unzweideutig zuzuordnen. In vielen Fällen wird es möglich sein, die x-Richtung des Lesegradienten so zu legen, daß eine solche eindeutige Zuordnung möglich ist.

Bei dem beschriebenen Verfahren liefert infolge der Rephasierung, die das von dem Gradientenimpuls 7 zusammen mit dem Lesegradienten 6 gebildeten Umkehrschema bewirkt, auch noch stationäres Material einen Signalanteil. Dieser Signalanteil kann dadurch eliminiert werden, daß vor Einstrahlen des der Anregung dienenden HF-Impulses eine Sättigung des anzuregenden Bereiches herbeigeführt wird, so daß nur noch solches Material kohärent angeregt und zur Bildung eines Echosignals veranlaßt werden kann, das nach dem Herstellen der Sättigung in die gesättigte Scheibe eingeflossen ist. Eine solche Sättigung der angeregten Scheibe kann dadurch erreicht werden, daß die einzelnen, durch jeweils einen HF-Impuls 2, 2', 2'' usw. ausgelösten Meßsequenzen so dicht aufeinanderfolgen, daß es dazwischen nicht zu einer mehr oder weniger vollständigen Relaxation der zuvor angeregten Spins kommen kann. In diesem Falle befindet sich die Magnetisierung des ausgewählten, scheibenförmigen Bereiches während der gesamten Aufnahme im gesättigten oder fast gesättigten Zustand und es wird das Signal im wesentlichen von während jeder Meßsequenz in den untersuchten Bereich eingeströmten Spins erzeugt.

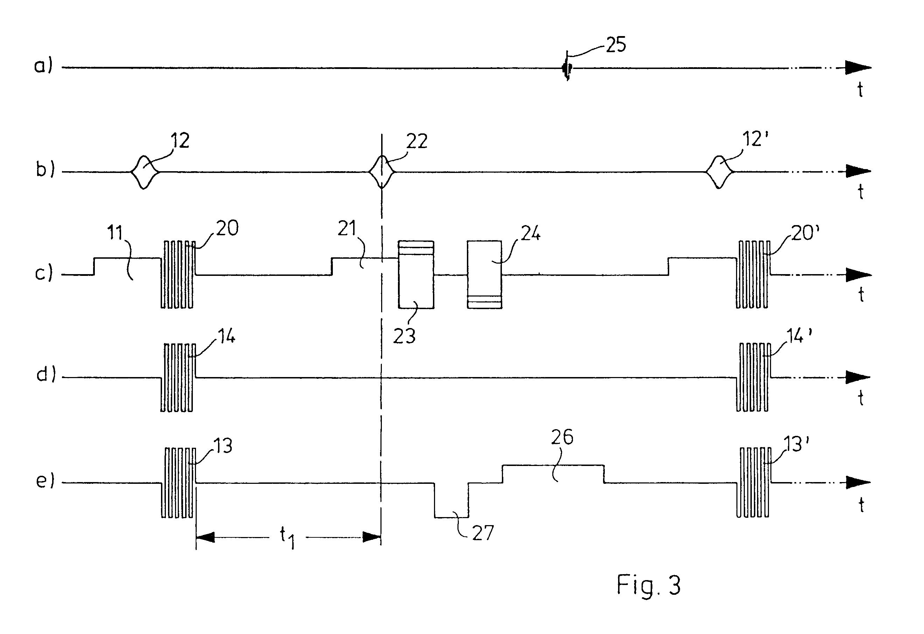

Es kann jedoch sein, daß die einzelnen Meßsequenzen nicht so dicht aufeinanderfolgend ausgelöst werden können, wie es zum erzielen eines Sättigungszustandes des gesamten angeregten Bereiches notwendig ist, beispielsweise dann, wenn pulsierende Materialströme zu untersuchen sind und daher die HF-Impulse synchron zur Periode des pulsierenden Material stroms ausgelöst werden müssen, damit jeweils die Fließgeschwindigkeit an einer bestimmten Stelle innerhalb der Periode des pulsierenden Materialstromes bestimmt werden kann. Um unabhängig von dem zeitlichen Abstand zwischen den der Anregung dienenden HF-Impulsen eine Sättigung herbeizuführen, wird gemäß der in Fig. 3 dargestellten Ausführungsform des erfindungsgemäßen Verfahrens nach einem ersten HF-Impuls 12, der bei eingeschaltetem Selektionsgradienten 11 eingestrahlt wird, dieser Selektionsgradient wiederholt schnell hin- und hergeschaltet, wie es durch die kurzen Impulse 20 des Selektionsgradienten in Fig. 3 veranschaulicht ist. Dadurch wird die Kohärenz der angeregten Spins sofort zerstört, und es befindet sich das System in dem durch den HF-Impuls 12 angeregten Bereich nunmehr in einem gesättigten Zustand. Durch einen weiteren HF-Impuls 22, der unter dem Selektionsgradienten 21 eingestrahlt wird, erfolgt dann ausschließlich eine Anregung desjenigen Materials, das in dem Zeitintervall $t_1$ zwischen dem Ende der Impulse 20 des Selektions-Gradienten und dem Einstrahlen des zweiten HF-Impulses 22 in den gesättigten und durch den zweiten HF-Impuls 22 in Verbindung mit dem Selektionsgradienten 21 wiederum selektiv angeregten Bereich eingeströmt ist. Die Erzeugung des Spinechosignals 25 unter der Einwirkung der Anteile 23, 24 des Flußphasengradienten und der Anteile 26, 27 des Lesegradienten erfolgt in der oben beschriebenen Weise. Auch hier werden die einzelnen Meßfrequenzen, von denen die nächste mit dem HF-Impuls 12' und dem Gradientenimpuls 20' beginnt, mehrfach hintereinander unter Veränderung des Flußphasengradienten 23, 24 ausgeführt, wie es für eine 2DFT-Rekonstruktion eines Bildes nach Fig. 2 erforderlich ist. Es sei noch erwähnt, daß bei der Ausführungsform des erfindungsgemäßen Verfahrens nach Fig. 3 außer dem Impuls 20 in Richtung des Selektionsgradienten auch durch mehrfaches Schalten erzeugte Impulse 13, 13' in Richtung des Lesegradienten sowie 14, 14' in der zum Selektionsgradienten und zum Lesegradienten senkrechten Richtung gemäß Zeile (d) erzeugt worden sind.

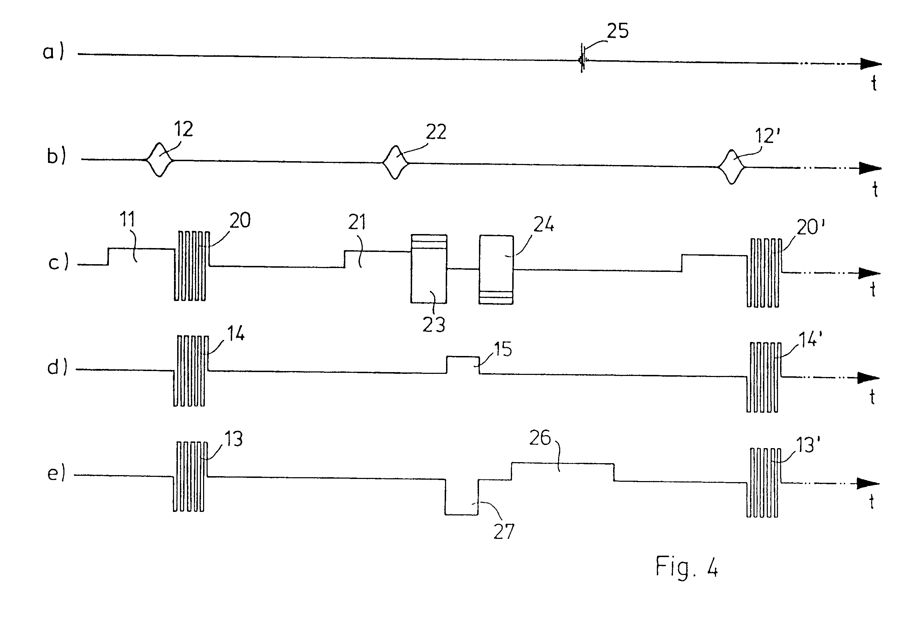

Die in Fig. 4 dargestellte Ausführungsform des erfindungsgemäßen Verfahrens unterscheidet sich von der Ausführungsform nach Fig. 3 lediglich dadurch, daß in der zur Richtung des Lesegradienten 26 senkrechten, in der Ebene des ausgewählten Bereiches liegenden Richtung ein weiterer, kurzer Gradientenimpuls 15 eingeschaltet wird, der sich zeitlich in dem Intervall zwischen den beiden Anteilen 23, 24 des Flußphasengradienten befindet. Dieser vor der eigentlichen Datenaufnahme wieder abgeschaltete Gradient bewirkt eine sinusartige Variation des Phasenwinkels der Magnetisierung in Richtung dieses Gradienten. Bei großflächigen Strukturen werden infolgedessen die Signale bei Mittelung über die Richtung dieses Gradienten ausgelöscht, während kleinere Strukturen, die bewegliches Material enthalten, nur eine unwesentliche Änderung ihrer Signalamplitude erleiden. Auch auf diese Weise wird eine Verbesserung der Unterdrückung von Signalen erreicht, die von stationärem Material stammen.

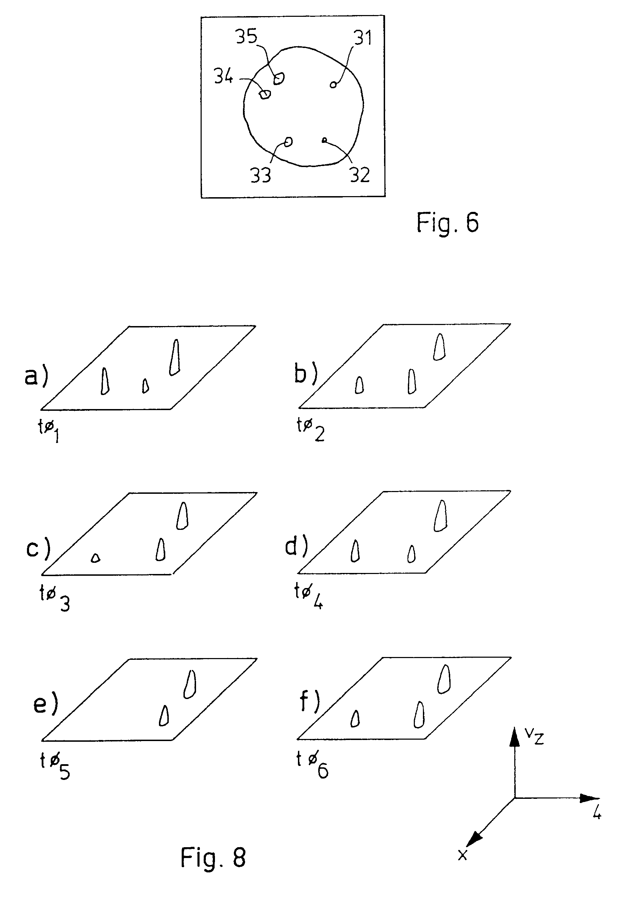

Die vorstehend beschriebenen Aufnahmeverfahren lassen sich leicht zu einem Mehrschichtenverfahren erweitern, indem vollständige Datensätze für mehrere in Richtung des Selektionsgradienten hintereinanderliegende, nacheinander angeregte scheibenförmige Bereiche aufgenommen werden. Aus den so erhaltenen pseudo-3D-Daten lassen sich Projektionsbilder eines Gefäßbaumes ableiten, die den Bildern ähnlich sind, die mittels Röntgen-Angiographie erhalten werden. Die auf diese Weise für eine Reihe von Querschnittsebenen erhaltenen Bilder nach Fig. 5a, die jeweils den Bildern nach Fig. 2 entsprechen, ergeben durch Projektion bzw. Integration über bestimmte Geschwindigkeitsbereiche das in Fig. 5b dargestellte Bild.

Für den Fall, daß das mit den bisher beschriebenen Ausführungsformen erhaltene Bild nach Fig. 2 keine eindeutige Zuordnung zwischen den Geschwindigkeitsprofilen und den Stellen ermöglicht, an denen sich fließendes Material befindet, erlaubt das erfindungsgemäße Verfahren auch eine vollständige Bilddarstellung des angeregten scheibenförmigen Bereiches, die eine genaue Zuordnung der Strömungsprofile zuläßt. Zu diesem Zweck genügt es, wiederum das beschriebene Verfahren zur Erzeugung einer Mehrzahl von Datensätzen anzuwenden, jedoch nicht unter Variation des Selektionsgradienten oder der Trägerfrequenz des HF-Impulses, durch den der ausgewählte Bereich in Richtung des Selektionsgradienten verschoben wird, sondern unter Änderung der Richtung des Lesegradienten, so daß eine Anzahl unterschiedlicher Datensätze gewonnen wird, die über eine 3DFT-Rekonstruktion die Erzeugung eines zweidimensionalen Bildes der Scheibe in Verbindung mit in der dritten Dimension aufgetragenen Geschwindigkeitskomponenten ergibt, die dann den einzelnen Stellen mit fließendem Material, als beispielsweise den Adern in einem Körperquerschnitt, eindeutig zugeordnet sind. Fig. 6 zeigt ein solches Querschnittsbild, in dem die Intensität und die Größe der Stellen 31 bis 35 charakteristisch für die Geschwindigkeit des an diesen Stellen vorhandenen, fließenden Materials sind. Es versteht sich, daß sich für diese Stellen nun auch die dort herrschenden Strömungsgeschwindigkeiten errechnen und mit hoher Genauigkeit angeben lassen.

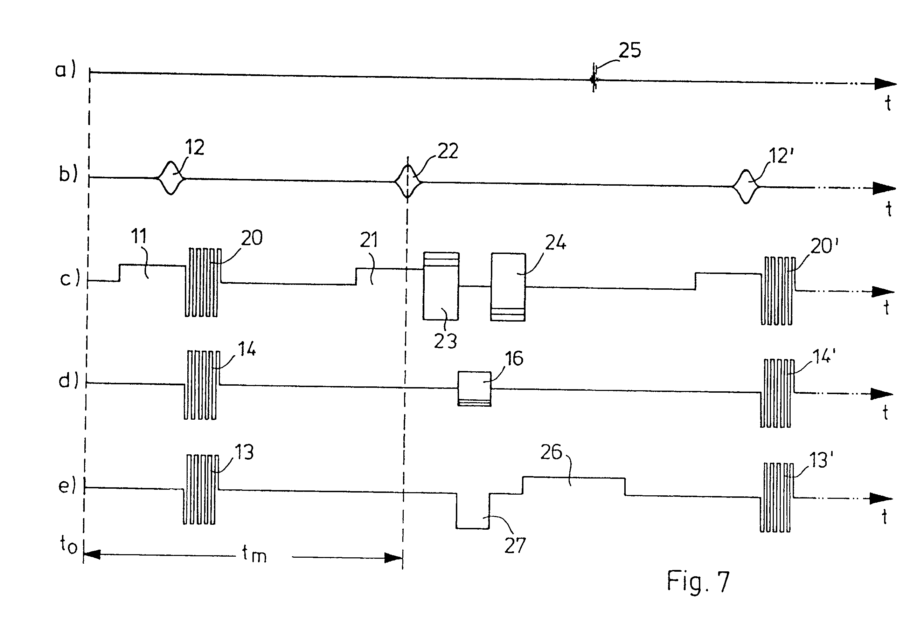

Eine andere Möglichkeit der Bilderzeugung besteht darin, eine Anzahl von Datensätzen mit unterschiedlichen Ortsphasengradienten aufzunehmen anstatt mit Lesegradienten unterschiedlicher Richtung. Diese Variante des erfindungsgemäßen Verfahrens ist in Fig. 7 dargestellt. Bei dieser Ausführungsform findet anstatt eines konstanten Gradientenimpulses 15 längs einer zum Selektionsgradienten und zum Lesegradienten senkrechten Richtung, wie er in Fig. 6 dargestellt ist, als Ortsphasengradient ein in einer Anzahl aufeinanderfolgender Datensätze wechselnder Phasencodierungsgradient 16 Verwendung, wie er auch sonst bei der NMR-Tomographie häufig verwendet wird. Auch hier ergibt wieder die 3DFT-Rekonstruktion Bilder, die in einer Ebene den angeregten scheibenförmigen Bereich und in der dazu senkrechten Ebene die Geschwindigkeit des in diesem Bereich vorhandenen Materials wiedergeben. Fig. 8 zeigt eine Anzahl a bis f solcher Bilder.

Wie bereits oben erwähnt, läßt sich das erfindungsgemäße Verfahren nicht nur dazu benutzen, stetige Materialströme, sondern auch pulsierende Materialströme zu untersuchen und das Geschwindigkeitsprofil des Materialstromes im Verlauf der Pulsperiode zu bestimmen, indem die Messung in unterschiedlichen zeitlichen Abständen vom Beginn der Pulsperiode vorgenommen wird. Bei klinischen Untersuchungen der Blutströme lassen sich beispielsweise die Messungen durch ein EKG-Signal auslösen, wie es in Fig. 7 zur Zeit $t_0$ angedeutet ist. Die in Fig. 8 dargestellten Bilder (a) bis (f) entsprechen unterschiedlichen zeitlichen Abständen $t_m$ zwischen dem durch das EKG-Signal angezeigten Beginn der Pulsperiode und dem den Zeitpunkt der Geschwindigkeitsmessung bestimmenden HF-Anregungsimpuls 22, der der durch den ersten HF-Anregungsimpuls 12 und die geschalteten Gradientenfelder 13, 14, 20 bestimmten Entwicklungsphase folgt. Diese Triggerung durch einen EKG-Impuls oder ein anderes Signal, das den Beginn der Pulsperiode eines pulsierenden Materialstromes angibt, ist bei allen bisher behandelten Verfahren möglich. Ist die Pulsperiode ausreichend lang, können während einer solchen Periode eine Anzahl von Meßsequenzen mit jeweils gleichem Flußphasengradienten vorgenommen werden. Diese Meßsequenzen liefern dann Signale, die verschiedenen Zeitpunkten während der Pulsperiode zugeordnet sind. Es lassen sich dann alle Signale zu jeweils einem Signalsatz zusammenfassen und verarbeiten, die dem gleichen Zeitpunkt innerhalb der Pulsperiode entsprechen, und in vergleichsweise kurzer Zeit die Geschwindigkeitsprofile über der Pulsperiode erstellen. Dies ist besonders dann von Bedeutung, wenn die Pulsperiode im Verhältnis zur Dauer der einzelnen Meßsequenzen groß ist, wie es insbesondere bei dem Pulsschlag des Menschen der Fall ist. Es versteht sich, daß die Aufnahme mehrerer Meßsequenzen innerhalb einer Pulsperiode zur Ermittlung des Geschwindigkeitsprofils von pulsierenden Materialströmen bei allen Varianten des erfindungsgemäßen Verfahrens und insbesondere bei allen vorstehend beschriebenen Verfahrensvarianten möglich ist.

Das erfindungsgemäße Verfahren ist nicht auf die vorstehend behandelten Ausführungsformen beschränkt, sondern es gibt viele Möglichkeiten, die Verfahrensschritte, in denen sich die behandelten Ausführungsformen von dem anhand Fig. 1 beschriebenen Grundverfahren unterscheiden, zu kombinieren. Weiterhin können bei dem erfindungsgemäßen Verfahren alle diejenigen Maßnahmen Anwendung finden, die auch sonst in der NMR-Tomographie üblich und zum Teil auch notwendig sind, um einwandfreie Ergebnisse zu erzielen. Dazu gehört beispielsweise die Maßnahme, den bei dem erfindungsgemäßen Verfahren angewendeten Flußphasengradienten mit einem konstanten Offset zu versehen, der dazu dient, die während der Scheibenselektion erfolgte und in Bezug auf das dadurch selektierte, fließende Material unerwünschte Dephasierung aufzuheben.

## Ansprüche

1. Verfahren zum Bestimmen von beweglichem, insbesondere fließendem Material innerhalb eines Körpers mittels NMR-Tomographie, bei dem der Körper einem homogenen Magnetfeld und periodisch aufeinanderfolgend impulsförmig angelegten Gradientenfeldern sowie zu den Gradientenfeldern zeitlich synchronisierten HF-Anregungsimpulsen ausgesetzt wird und die Gradientenfelder derart variiert werden, daß bei jeder durch einen HF-Anregungsimpuls ausgelösten Meßsequenz die sich in einem ausgewählten Bereich des Körpers befindlichen Spins angeregt und zur Erzeugung von Spinechosignalen veranlaßt werden und durch Fourier-Transformation eines Satzes der während der Meßsequenzen empfangenen Spinechosignale neben der räumlichen Auflösung des ausgewählten Bereiches auch eine Information über die Geschwindigkeit des beweglichen Materials erhalten wird, das sich innerhalb dieses Bereiches befindet, wobei zuerst bei Anliegen eines Slecktionsgradienten (1 ; 11) durch einen HF-Impuls (2 ; 12) ein scheibenförmiger Bereich des Körpers angeregt wird, danach ein zum Selectionsgradienten gleichgerichteter Flußphasengradient angelegt wird, der zwei aufeinanderfolgende, entgegengesetzt gleiche Abschnitte (3, 4 ; 23, 24) aufweist, so daß die Erzeugung von Spinechosignalen (5 ; 25) bewirken, und daß wenigstens für die Zeit des Auftretens des Spinechosignals (5 ; 25) ein Lesegradient (6 ; 26) angelegt wird, der zum Selektionsgradienten (3, 4 ; 23, 24) senkrecht steht, so daß die 2DFT-Rekonstruktion eines Satzes von Spinechosignalen ein Bild liefert, das in einer Richtung die räumliche Koordinate des Lesegradienten und in der zweiten die Strömungsgeschwindigkeit des senkrecht zur Scheibe fließenden Materials enthält, dadurch gekennzeichnet, daß

   – die einander entgegengesetzt gleichen Abschnitte (3, 4 ; 23, 24) des Flußphasengradienten mit einem zeitlichen Abstand aufeinanderfolgen,

   – die Größe der einander entgegengesetzt gleichen Abschnitte (3, 4 ; 23, 24) des Flußphasengradienten bei aufeinanderfolgenden Anregungen variiert wird, und

   – dem Lesegradienten ein entgegengesetzter Gradientenimpuls (7 ; 27) vorausgeht, der in dem Zeitinterwall zwischen den beiden Abschnitten (3, 4 ; 23, 24) des Flußphasengradienten angelegt wird, und zusammen mit dem Lesegradienten (6 ; 26) ebenfalls die Erzeugung eines Echosignals zur gleichen Zeit bewirkt wie die Abschnitte (3, 4 ; 23 ; 24) des Flußphasengradienten.

2. Verfahren nach Anspruch 1, dadurch gekennzeichnet, daß die zur Erzeugung eines Signalsatzes erforderlichen Anregungen so dicht aufeinanderfolgen, daß eine Sättigung des angeregten Bereiches eintritt.

3. Verfahren nach Anspruch 1 oder 2, dadurch gekennzeichnet, daß der Körper nach dem ersten HF-Impuls (12) einem schnell wechselnden Gradientenfeld (13, 14, 20) ausgesetzt wird, das durch Dephasierung der angeregten Spins eine wenigstens annähernd vollständige Sättigung des angeregten Bereiches bewirkt, bevor ein weiterer HF-Impuls (22) zur Anregung von beweglichem Material eingestrahlt wird, das nach dem ersten HF-Impuls (12) in den zuvor gesättigten Bereich gelangt ist und das dann die Spinechosignale (25) liefert.

4. Verfahren nach einem der vorhergehenden Ansprüche zur Untersuchung pulsierender Materialströme, insbesondere des Blutflusses in lebenden Körpern, dadurch gekennzeichnet, daß die HF-Impulse (12, 22) synchron zur Periode des pulsierenden Materialstroms ausgelöst werden.

5. Verfahren nach Anspruch 4, dadurch gekennzeichnet, daß während jeder Periode des pulsierenden Materialstromes mehrere durch HF-Impulse (12, 12') angeregte Meßsequenzen stattfinden, ohne daß dabei der Flußphasengradient (23, 24) geändert wird, und für die 2DFT-Rekonstruktion diejenigen Spinechosignale zu Sätzen zusammengefaßt werden, die von der gleichen Meßsequenz innerhalb der Periode des pulsierenden Materialstromes stammen.

6. Verfahren nach einem der vorhergehenden Ansprüche, dadurch gekennzeichnet, daß der Körper nach der Anregung durch einen HF-Impuls (12, 22), vorzugsweise im Intervall zwischen den Abschnitten (23, 24) des Flußphasengradienten, in einer zur Richtung des Selektionsgradienten senkrechten und von der Richtung des Lesegradienten abweichenden, vorzugsweise zu dessen Richtung ebenfalls senkrechten Richtung einem Ortsphasengradienten (16) ausgesetzt wird, dessen Größe nach jeweils einem sich aus der Variation des Flußphasengradienten ergebenden vollständigen Satz von Meßsequenzen geändert wird, und daß dann die erhaltenen Spinechosignale nach einer 3DFT-Rekonstruktion verarbeitet werden, so daß sie ein zweidimensionales Bild ergeben, dem in der dritten Dimension die Strömungsgeschwindigkeiten des beweglichen Materials zugeordnet sind.

7. Verfahren nach einem der Ansprüche 1 bis 5, dadurch gekennzeichnet, daß der Körper nach der Anregung durch einen HF-Impuls (22), vorzugsweise im Intervall zwischen den Abschnitten (23, 24) des Flußphasengradienten, in einer zur Richtung des Selektionsgradientensenkrechten und von der Richtung des Lesegradienten abweichenden, vorzugsweise zu dessen Richtung ebenfalls senkrechten Richtung einem Phasengradienten (15) konstanter Größe ausgesetzt wird, der eine Dephasierung und damit eine Unterdrückung der Signale großflächiger Konturen bewirkt.

8. Verfahren nach einem der vorhergehenden Ansprüche, dadurch gekennzeichnet, daß mehrere Sätze von Spinechosignalen für mehrere parallele Scheiben erzeugt und diese Sätze zu einer dreidimensionalen Darstellung des Fließverhaltens über eine gewisse Länge des untersuchten Körpers verarbeitet werden.

## Claims

1. Method for the identification of movable, particularly flowing matter within a body by means of NMR-tomography, in which the body is exposed to a homogeneous magnetic field and periodic successive gradient fields applied in pulse-like manner, as well as r.f. excitation pulses time synchronized with the gradient fields and the gradient fields are varied in such a way that for each measurement sequence initiated by a r.f. excitation pulse the spins located in a selected region of the body are excited and made to generate spin echo signals and information is obtained on the speed of the movable material located within this area by Fourier transformation of a set of the spin echo signals received during the measurement sequences, in addition to the spatial resolution of the selected area, in which initially a slice-like region of the body is excited by an r.f. pulse (2, 12) in the presence of a selection gradient (1, 11), after which a flow phase gradient equi-directional with respect to the selection gradient is applied and has two successive, opposite, identical portions (3, 4 ; 23, 24), so that they lead to the generation of spin echo signals (5, 25) and that a reading gradient (6, 26) is applied at least for the time of the occurrence of the spin echo signal (5, 25) and is at right angles to the selection gradient (3, 4 ; 23, 24), so that the 2DFT reconstruction of a set of spin echo signals supplies an image or picture containing in one direction the spatial coordinates of the reading gradient and in the second direction the flow rate of the matter flowing at right angles to the slice, characterized in that opposing, identical portions (3, 4 ; 23, 24) of the flow phase gradient succeed one another with a time interval, the size of said portions (3, 4 ; 23, 24) of the flow phase gradient is varied during succeeding excitations and the reading gradient is preceded by an opposite gradient pulse (7, 27), which is applied in the time interval between the two portions (3, 4 ; 23, 24) of the flow phase gradient and, together with the reading gradient (6, 26), also brings about the generation of an echo signal at the same time as the portions (3, 4 ; 23, 24) of the flow phase gradient.

2. Method according to claim 1, characterized in that the excitations necessary for generating a set of signals follow one another so closely as to saturate the excited area.

3. Method according to claim 1 or 2, characterized in that, following the first r.f. pulse (12), the body is exposed to a rapidly changing gradient field (13, 14, 20) which, by dephasing the excited spin, brings about an at least approximately complete saturation of the excited area, prior to the application of a further r.f. pulse (22) for exciting the movable matter, which reaches the previously saturated area after the first r.f. pulse (12) and then yields the spin echo signals (25).

4. Method according to one of the preceding claims for investigating pulsating material flows, particularly the blood flow in living bodies, characterized in that the r.f. pulses (12, 22) are triggered synchronously to the cycle of the pulsating material flow.

5. Method according to claim 4, characterized in that during each cycle of the pulsating material flow several measurement sequences excited by r.f. pulses (12, 12') take place without thereby modifying the flow phase gradient (23, 24) and for 2DFT reconstruction those spin echo signals are combined into sets which come from the same measurement sequence within the cycle of the pulsating material flow.

6. Method according to one of the preceding claims, characterized in that following excitation by an r.f. pulse (12, 22), preferably in the interval between the portions (23, 24) of the flow phase gradient, in a direction at right angles to the selection gradient direction and differing from the reading gradient direction and preferably also at right angles thereto, the body is exposed to a local phase gradient (16), whose size is modified after a complete set of measurement sequences resulting from the variation of the flow phase gradient and that then the spin echo signals obtained are processed after 3DFT reconstruction, so that they give a two-dimensional image, with which is associated in the third dimension the flow rates of the movable matter.

7. Method according to one of the claims 1 to 5, characterized in that, after excitation by an r.f. pulse (22), preferably in the interval between the portions (23, 24) of the flow phase gradient, in a direction at right angles to the selection gradient direction and diverging from the reading gradient direction and preferably also at right angles thereto, the body is exposed to a phase gradient (15) of constant magnitude, which brings about a dephasing and therefore a suppression of the signals of large-area contours.

8. Method according to one of the preceding claims, characterized in that several sets of spin echo signals are generated for several parallel slices and said sets are processed to a three-dimensional representation of the flow behaviour over a certain length of the examined body.

## Revendications

1. Procédé pour déterminer une substance mobile, notamment en écoulement, à l'intérieur d'un corps au moyen de la tomographie RMN, et selon lequel on soumet le corps à un champ magnétique homogène et à des champs de gradients appliqués successivement et périodiquement sous forme impulsionnelle, ainsi qu'à des impulsions d'excitation HF synchronisées dans le temps avec les champs de gradients et qu'on modifie les champs de gradient de manière que, pour chaque séquence de mesure déclenchée par une impulsion d'excitation HF, les spins situés dans une région sélectionnée du corps sont excités et sont déclenchés pour la production de signaux d'échos de spins et que, grâce à une trans formation de Fourier d'un ensemble des signaux d'échos de spins reçus pendant les séquences de mesure, on obtient non seulement la résolution spatiale de la région sélectionnée, mais également une information concernant la vitesse de la substance mobile, qui est située dans cette région, et selon lequel tout d'abord, et en présence d'un gradient de sélection (1 ; 11), on excite au moyen d'une impulsion HF (2 ; 12) une région en forme de tranche du corps, puis on applique un gradient de phase d'écoulement, dirigé dans le même sens que le gradient de sélection et possédant deux sections successives, identiques et opposées (3, 4 ; 23, 24), en sorte qu'elles déclenchent la production de signaux d'échos de spins (5 ; 25), et qu'au moins pendant la durée de l'apparition du signal d'écho de spin (5 ; 25), on applique un gradient de lecture (6 ; 26), qui est perpendiculaire au gradient de sélection (3, 4 ; 23, 24) de sorte que la reconstitution 2DFT d'un ensemble de signaux d'échos de spins fournit une image, qui contient, dans une direction, la coordonnée spatiale du gradient de lecture et, dans la seconde direction, la vitesse d'écoulement de la substance circulant perpendiculairement à la tranche,
caractérisé par le fait que

— les sections identiques (3, 4 ;23, 24), opposées l'une à l'autre, du gradient de la phase d'écoulement se succèdent en étant séparées par un intervalle de temps,

— la grandeur des sections identiques (3, 4 ; 23, 24), opposées l'une à l'autre, du gradient de phase d'écoulement est modifiée lors d'excitations successives, et

— une impulsion opposée de gradient (7 ; 27), qui est appliquée pendant l'intervalle de temps s'étendant entre les deux sections (3, 4 ;23, 24) du gradient de phase d'écoulement, précède le gradient de lecture et déclenche également, conjointement avec le gradient de lecture (6 ; 26), la production d'un signal d'écho au même instant que les sections (3, 4 ; 23, 24) du gradient de phase d'écoulement.

2. Procédé suivant la revendication 1, caractérisé par le fait que les excitations nécessaires pour la production d'un ensemble de signaux se succèdent avec une densité telle qu'il apparaît une saturation de la région excitée.

3. Procédé suivant la revendication 1 ou 2, caractérisé par le fait qu'après la première impulsion HF (12), on soumet le corps à un champ de gradient (13, 14, 20), qui présente une variation alternative rapide et déclenche, en raison du déphasage des spins excités, une saturation au moins approximativement complète de la région excitée, avant l'envoi d'une autre impulsion HF (22) servant à exciter la substance mobile et qui parvient, après la première impulsion HF (12), dans la zone préalablement saturée et produit alors les signaux d'échos de spins (25).

4. Procédé suivant l'une des revendications précédentes pour l'examen d'écoulements pulsatoires d'une substance, notamment du flux sanguin dans des corps vivants, caractérisé par le fait que les impulsions HF (12, 22) sont déclenchées d'une manière synchrone avec la période de l'écoulement pulsatoire de la substance.

5. Procédé suivant la revendication 4, caractérisé par le fait que pendant chaque période de l'écoulement pulsatoire de la substance, il apparaît plusieurs séquences de mesure déclenchées par des impulsions HF (12, 12'), sans que le gradient de phase d'écoulement (23, 24) soit modifié, et, pour la reconstitution 2DFT, les signaux d'échos de spins sont réunis sous la forme d'ensembles qui proviennent de la même séquence de mesure au cours de la période de l'écoulement pulsatoire de la substance.

6. Procédé suivant l'une des revendications précédentes, caractérisé par le fait qu'après excitation du corps par une impulsion HF (12, 22), de préférence pendant l'intervalle de temps entre les sections (23, 24) du gradient de phase d'écoulement, dans une direction perpendiculaire à la direction du gradient de sélection et qui diffère de la direction du gradient de lecture et de préférence est également perpendiculaire à cette direction, on soumet le corps à un gradient de phase local (16), dont la valeur est modifiée en fonction d'un ensemble complet de séquences de mesure, qui est fourni par la variation du gradient de phase d'écoulement, et qu'ensuite on traite les signaux d'échos de spins obtenus conformément à une reconstitution 3DFT, de telle sorte qu'ils fournissent une image bidimensionnelle à laquelle sont associées, dans la troisième dimension, les vitesses d'écoulement de la substance mobile.

7. Procédé suivant l'une des revendications 1 à 5, caractérisé par le fait qu'après excitation du corps par une impulsion HF (12, 22), de préférence pendant l'intervalle de temps entre les sections (23, 24) du gradient de phase d'écoulement, dans une direction perpendiculaire à la direction du gradient de sélection et qui diffère de la direction du gradient de lecture et de préférence est également perpendiculaire à cette direction, on soumet le corps à un gradient de phase (15) de valeur constante qui provoque un déphasage et par conséquent une suppression des signaux présentant des contours de surface étendue.

8. Procédé suivant l'une des revendications précédentes, caractérisé par le fait que plusieurs ensembles de signaux d'échos de spins sont produits pour plusieurs tranches parallèles et que ces ensembles sont traités pour obtenir une représentation tridimensionnelle du comportement de l'écoulement, sur une certaine longueur du corps examiné.

Fig. 1

EP 0 267 375 B1

Fig. 2

Fig. 5

a)

b)

Fig. 3

EP 0 267 375 B1

Fig. 4

EP 0 267 375 B1

Fig. 6

Fig. 8

Fig. 7

EP 0 267 375 B1